# EUROPEAN PATENT SPECIFICATION

(11) **EP 1 096 680 B1**
(45) Date of publication and mention of the grant of the patent: **26.12.2007**
(21) Application number: 00309156.8
(22) Date of filing: 18.10.2000
(51) Int. Cl.: H03K 7/08

(54) **A pulse width modulation circuit**
Schaltung zur Pulsbreitenmodulation
Circuit à modulation de largeur d'impulsions

(30) Priority: 28.10.1999 US 428822
(43) Date of publication of application: 02.05.2001
(73) Proprietor: Xerox Corporation, Rochester, New York 14644 (US)
(72) Inventor: Yazdy, Mostafa R., Los Angeles, CA 90066 (US)
(74) Representative: W.P. Thompson & Co.

(56) References cited:
- PATENT ABSTRACTS OF JAPAN vol. 0185, no. 51 (E-1619), 20 October 1994 (1994-10-20) & JP 6 197562 A (CANON INC), 15 July 1994 (1994-07-15)
- PATENT ABSTRACTS OF JAPAN vol. 1997, no. 02, 28 February 1997 (1997-02-28) & JP 8 256137 A (FUJITSU LTD), 1 October 1996 (1996-10-01)

## Description

This invention relates to pulse width modulation and more particularly to a logic design which significantly reduces the number of required logic blocks and the size of the chip containing the pulse width modulation logic.

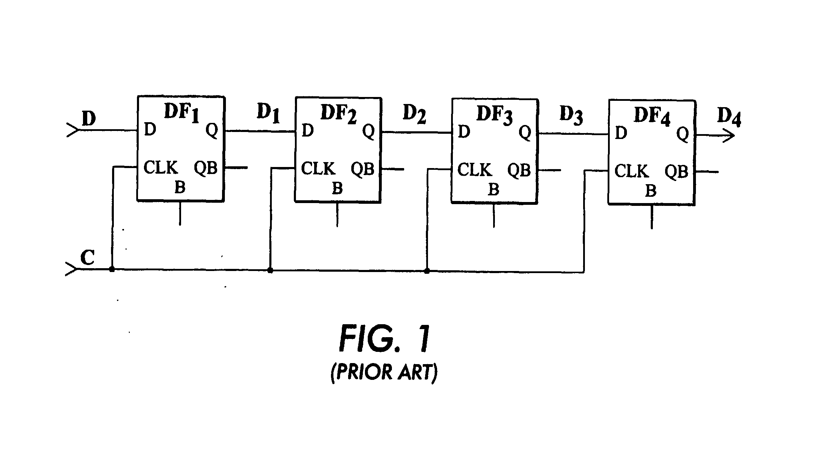

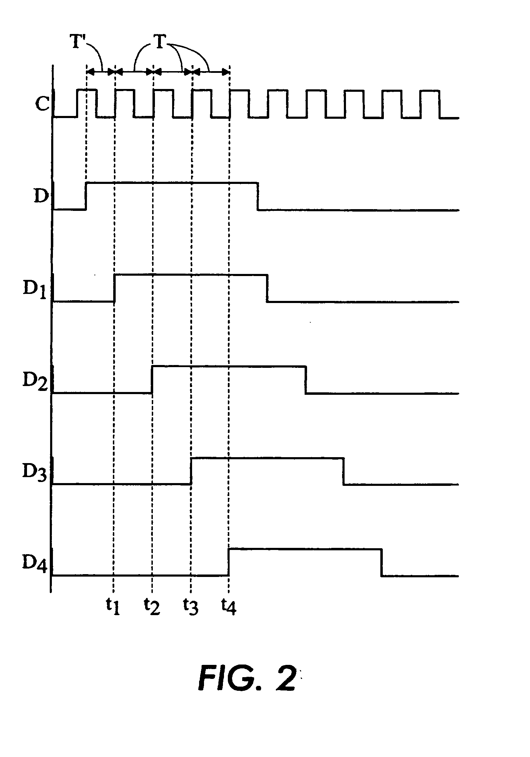

Typically, for pulse width modulation using digit delay, a logic design with numerous logic blocks such as D flip flops are needed. Referring to Figure 1, there is shown a prior art logic diagram which utilizes four positive edge triggered D flip flops to delay a signal for 4 clock cycles. Referring to Figure 2, there are shown signals of a clock C, an input signal D, and output signals D₁, D₂, D₃, and D₄. Referring to both Figures 1 and 2, the input signal D is applied to DF₁ which will be held until the rising edge t₁ of the clock C sends out the input D to the output D₁. As a result, input D is delayed by T'. D₁ reaches DF₂ slightly after the rising edge t₁ of clock C reaches DF₂. Therefore, D₁ will be sent to the next flip flop DF₃ on the rising edge t₂ of the clock C. As a result, the delay created by DF₂ is T which is equal to one cycle of clock C. In the same manner the delay created by DF₃ and DF₄ each is equal to one period T of the clock C.

The logic block diagram of Figure 1 is a typical delay logic. Using this logic design requires a number of flip flops equal to the required number of delays. For example, if 32T delays are required, 32 flip flops will be needed. This design can become quite large if a delay of for example up to 64T is needed for 32 lines. This means that each line has to have 64 flip flops resulting in total 32 X 64 = 2068 flip flops.

Another type of pulse modulator incorporating counter chains is known from JP 06 197 562 A.

It is an object of this invention to reduce the number of flip flops and the size and cost of a chip containing pulse width modulation circuit with plurality of delay requirements.

In accordance with one aspect of this invention, a pulse width modulation circuit comprises a clock dividing block for receiving a system clock and generating a plurality of clocks with different clock cycles. A delaying block receives a signal and delays the signal. The delaying block has a plurality of delaying elements. Each one of the plurality of delaying elements receives one of the plurality of clocks. The delaying block receives a delay data and responds to the delay data for selecting a number of the plurality of clocks based on the delay data and activates the respective delaying elements. The delaying block is so constructed and arranged to cause the signal to pass through the activated delaying elements and bypass the inactivated delaying elements.

In accordance with another aspect of this invention, a pulse width modulation circuit comprises a clock dividing block for receiving a system clock and generating a plurality of clocks with different clock cycles. A plurality of delaying blocks receive a signal and delay the signal according to a plurality of data. Each of the delaying block has a plurality of delaying elements. Each of the plurality of delaying elements of each delaying blocks receives one of the plurality of clocks. Each of the plurality of delaying blocks receives one of the plurality of delay data and responds to the respective delay data for selecting a number of the plurality of clocks based on the delay data and activates the respective delaying elements. Each of the delaying blocks being so constructed and arranged to cause the signal to pass through the respective activated delaying elements and bypass the respective inactivated delaying elements.

Embodiments of the present invention will now be described, by way of example, with reference to the accompanying drawings, in which:
Figure 1 shows a prior art D flip flop logic required for 4 clock cycle delays;
Figure 2 shows a clock, input signal, and a plurality of output signals applied to logic design of Figure 1;
Figure 3 shows a block diagram of the delay logic of this invention;
Figure 4 shows a detail block diagram of the clock divider of Figure 3;
Figure 5 shows different periods of clocks of Figure 3;
Figure 6 shows a logic diagram of one of the delay blocks.;
Figure 7 shows the signals of Figure 6 for a delay of 35T;
Figure 8 shows the logic diagram of Figure 6 with the addition of reset connections; Figure 9 shows how the delay logic of Figure 3 provides pulse width modulation; and
Figure 10 shows an alternative pulse width modulation through delaying the opposite edge of the input pulse.

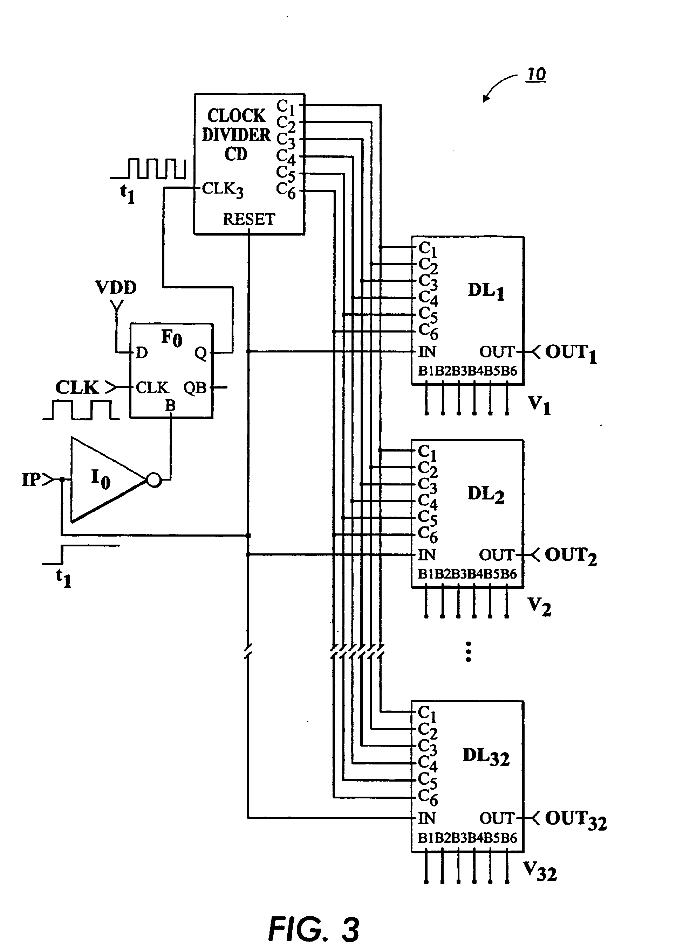

Referring to Figure 3, there is shown a block diagram of the delay logic 10 of this invention. In Figure 3, a clock divider CD divides the system clock CLK and generates 6 clocks C₁, C₂, C₃, C₄, C₅, and C₆ with periods of T, 2T, 4T, 8T, 16T, and 32T and sends them to the delay logic blocks DL₁-DL₃₂ of different lines.

Referring back to Figures 1 and 2, flip flop DF₁ delays signal D by T' since the rising edge happens between the two rising edges of the clock C. In order to prevent partial delay, in Figure 3, flip flop F₀ is placed in the path of system clock CLK to the clock divider CD. The D input of flip flop F₀ is connected to VDD to continuously keep the D input of flip flop F₀ at high (1). The positive output (Q) of F₀ is connected to the clock divider CD. The input pulse which needs to be delayed, is connected to the Reset line of the F₀ through an inverter 10. The clock input of flip flop F₀ receives the system clock CLK.

In operation, flip flop F₀ keeps the system clock CLK until it receives the rising edge of IP which inactivates the reset of flip flop F₀. Then, F₀ sends out the system clock as a synchronized clock CLK_{S} to the CD block. Since CLK_{S} is synchronized with the input pulse IP, the input pulse IP will receive full delays.

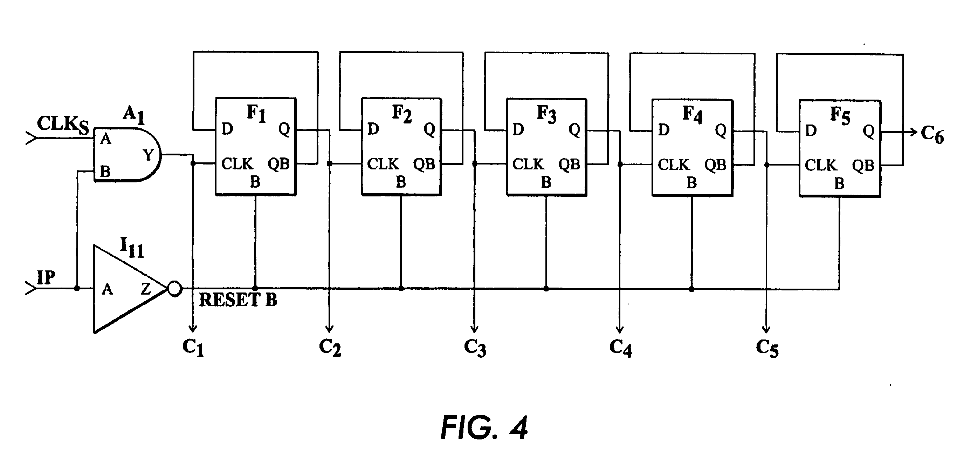

Referring to Figure 4, there is shown a detail block diagram of the clock divider CD of Figure 3. In Figure 4, the system reset input pulse IP is sent to the reset pin of flip flops F₁, F₂, F₃, F₄, and F₅ through inverter I₁₁. The synchronized system clock CLK_{S} and the input pulse IP are sent to an AND gate A₁ to generate a resetable clock C₁ with the same period as the synchronized system clock CLK_{S}. To divide clock C₁, five flip flops F₁, F₂, F₃, F₄, and F₅ are used. C₁ is sent to F₁ as a clock. The negative output (QB) of each one of the flip flops F₁, F₂, F₃, F₄, and F₅ is connected to its input. This configuration causes each flip flop F₁, F₂, F₃, F₄, and F₅ to divide its clock by 2. The positive output (Q) of each flip flop F₁, F₂, F₃, F₄, and F₅ is connected to the clock of the following flip flop. In addition, the positive output of flip flops F₁, F₂, F₃, F₄, and F₅ are sent out as clocks C₂, C₃, C₄, C₅, and C₆ respectively.

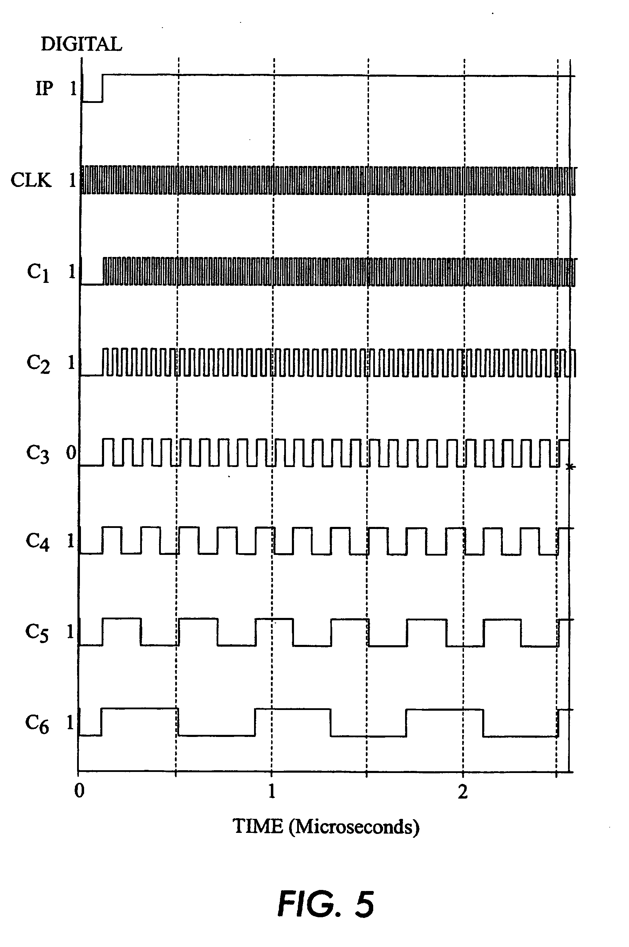

Since each flip flop F₁, F₂, F₃, F₄, and F₅ divides its clock by 2 and sends it out on its positive output, C₂ has a period twice as its input clock. Since the period of clock C₁ is equal to the period T of the synchronized system clock CLKs, the period of clock C₂ is 2T. In the same manner, the periods of clocks C₃, C₄, C₅, and C₆ are 4T, 8T, 16T, and 32T as shown in Figure 5.

Referring back to Figure 3, clocks C₁, C₂ C₃, C₄, C₅, and C₆ are sent to all delay bocks DL₁-DL3₂ where each delay block selects a combination of the clocks C₁, C₂, C₃, C₄, C₅, and C₆ to create a required delay. Each delay block DL₁-DL₃₂ receives the input pulse IP and a six bit delay value V₁-V₃₂. By using clocks C₁, C₂, C₃, C₄, C₅, and C₆, each delay block DL₁- DL₃₂ delays the input pulse IP according to its respective delay value V₁-V₃₂ and sends it out on its output OUT₁-OUT₃₂ respectively.

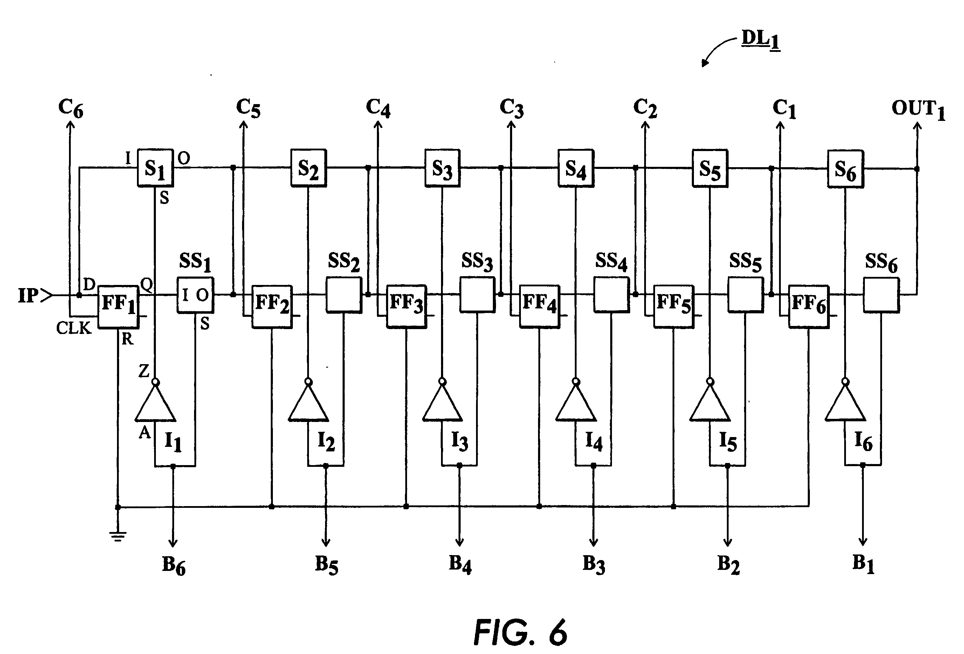

Referring To Figure 6, there is shown a logic diagram one of the delay block DL₁. It should be noted that the delay blocks DL₂-DL₃₂ are identical to DL₁. In delay block DL₁, there are six D flip flops FF₁, FF₂, FF₃, FF₄, FF₅, FF₆. The clock inputs of the flip flops FF₁, FF₂, FF₃, FF₄, FF₅, FF₆ are connected to the clocks C₆, C₅, C₄, C₃, C₂, and C₁ respectively.

The positive output of each flip flop FF₁, FF₂, FF₃, FF₄, and FF₅ is connected to the input of the following flip flop through switches SS₁, SS₂, SS₃, SS₄, and SS₅ respectively. The positive output of flip flop FF₆ is connected to the output OUT₁ of the delay line1 through switch SS₆. The input of each flip flop FF₁, FF₂, FF₃, FF₄, FF₅, FF₆ is connected to the input of the following flip flop through switches S₁, S₂, S₃, S₄, S₅, and S₆ respectively.

Each delay block DL₁-DL₃₂ of Figure 3 receives a separate delay value through V₁-V₃₂ respectively. Each V₁-V₃₂ has six bits B₁, B₂, B₃, B₄, B₅, and B₆ which deliver a number between 0 to 63. B₁, B₂, B₃, B₄, B₅, and B₆ are directly connected to the control pins of switches SS₁, SS₂, SS₃, SS₄, SS₅, and SS₆ respectively and connected to the control pins of switches S₁, S₂, S₃, S₄, S₅, and S₆ through inverters I₁, I₂, I₃, I₄, I₅, and I₆ respectively.

In Figure 6, every time one of the bits B₆, B₅, B₄, B₃, B₂, and _{B1} is high (1), its respective switch SS₁, SS₂, SS₃, SS₄, SS₅, and SS₆ closes. For example, if B₄ is high (1) switch SS₃ closes and connects the positive output of FF₃ to the input of FF₄. However, every time one of the bits B₆, B₅, B₄, B₃, B₂, and B₁ is low (0), its respective switch S₁, S₂, S₃, S₄, S₅, and S₆ closes. For example, if B₄ is low (0) switch S₃ closes and connects the input of FF₃ to the input of FF₄. In other words, when one of the bits B₆, B₅, B₄, B₃, _{B2}, and B₁ is high (1), the output of the previous flip flop is delivered to the input of the following flip flop, but if it is low (0), the previous flip flop is by passed and its input is delivered to the input of the next flip flop.

With the configuration of Figure 6, the high (1) bits B₆, B₅, B₄, B₃, B₂, and B₁ select the proper delay. For example, if the six bits B₆, B₅, B₄, B₃, B₂, and B₁ represent 100011, it means 32+2+1=35 delay is needed. Since B₆ is (1), switch SS₁ closes and flip flop FF₁ becomes active. Therefore, the input of flip flop FF₁ is delayed by 32T since FF₁ is clocked by clock C₆ which has a clock cycle of 32T. It should be noted that the input of the flip flop FF₁ is the input pulse IP that has to be delayed. Since, bits B₅, B₄, and B₃ are zero, switches S₂, S₃, and _{S4} close, by pass flip flops FF₂, FF₃, and FF₄, and deliver the output of flip flop FF₁ to the input of FF₅.

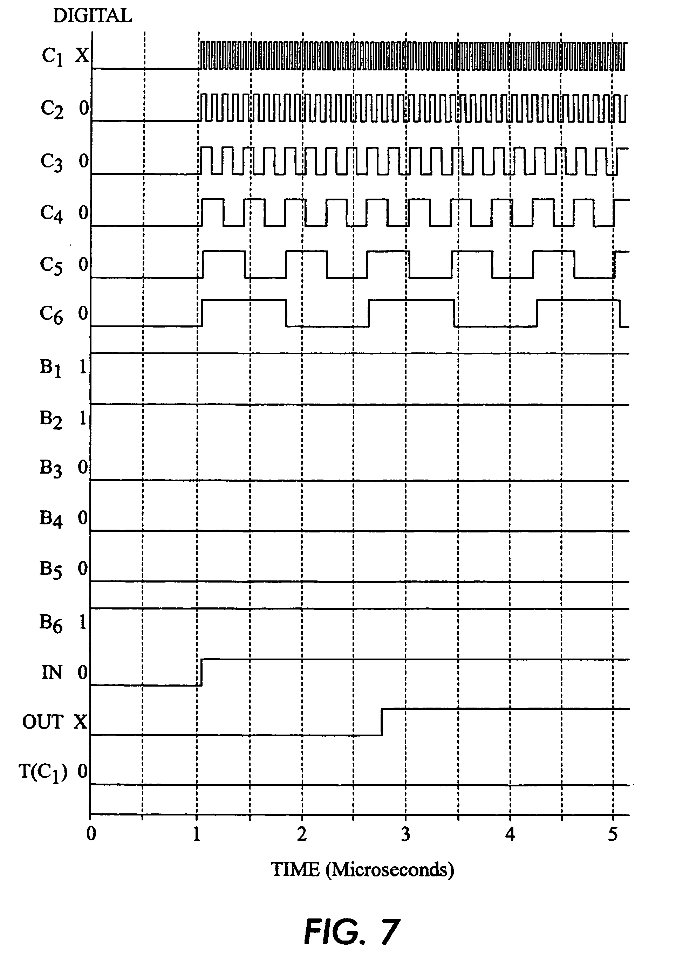

Since bits B₂ and B₁ are high (1), both switches SS₅ and SS₆ close and activate flip flops FF₅ and _{FF6}. Since flip flop FF₅ receives clock C₂, it delays its input (output of FF₁ which is delayed by 32T) by 2T. Therefore, the output of flip flop FF₅ is delayed by 32T+2T=34T. Flip flop FF₆ uses clock C₁ which has a delay of T. Subsequently, flip flop FF₆ delays the output of FF₅ by T. Therefore the output of flip flop FF₆ which through switch SS₆ is connected to the OUT₁ provides a signal with 35T delay. The result is shown in Figure 7.

At the power on, the outputs of the flip flops FF₁, FF₂, FF₃, FF₄, FF₅, and FF₆ can be at don't care (unknown) state. In order to prevent any error in the delay circuit, flip flops FF₁, FF₂, FF₃, FF₄, FF₅, and FF₆ have to receive a reset.

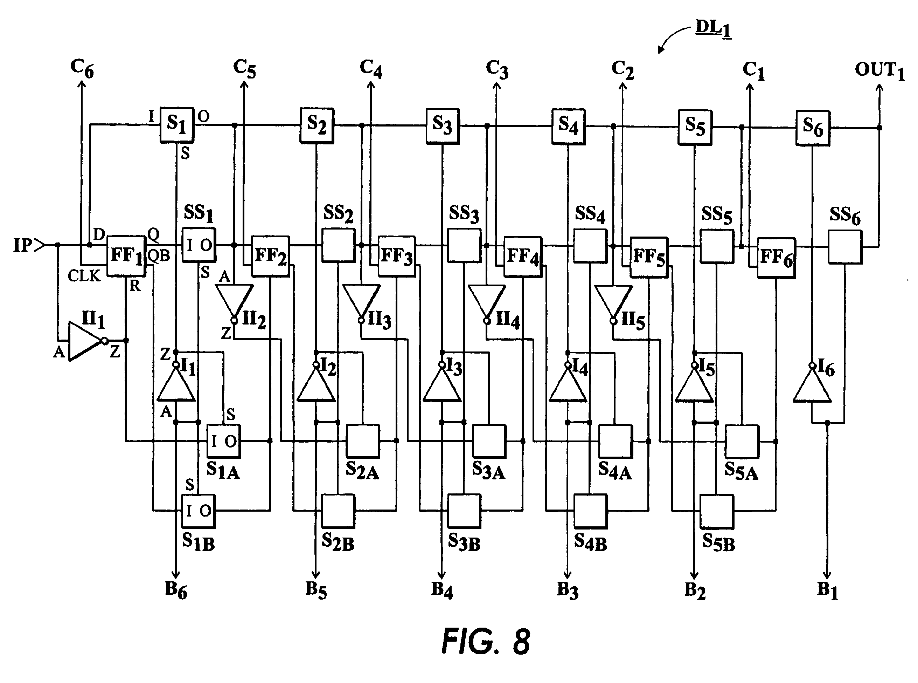

Referring to Figure 8, there is shown the logic diagram of Figure 6 with the addition of reset connections. Each flip flop FF₂, FF₃, FF₄, FF₅, and FF₆ receives a Reset signal from one of two switches (S_{1A} and S_{1B}), (S_{2A} and S_{2B}), (S_{3A} and S_{3B}), (S_{4A} and S_{4B}), and (S_{5A} and S_{5B}) respectively. The control pins of switches S_{1B}, S_{2B}, S_{3B}, S_{4B}, and S_{5B} are connected to B₆, B₅, B₄, B₃, and B₂ respectively. However, the control pins of switches S_{1A}, S_{2A}, S_{3A}, S_{4A}, and S_{5A} are connected to B₆, B₅, B₄, B₃, and B₂ through inverters I₁, I₂, I₃, I₄, and I₅ respectively. The negative output (QB) of flip flops FF₁, FF₂, FF₃, FF₄, and FF₅ are connected to the reset pin of flip flops FF₂, FF₃, FF₄, FF₅, and FF₆ through switches S_{1B}, S_{2B}, S_{3B}, S_{4B}, and S_{5B}. Furthermore, the input of flip flops FF₁, FF₂, FF₃, FF₄, and FF₅ are connected to the reset pin of flip flops FF₂, FF₃, FF₄, FF₅, and FF₆ through inverters and switches (II₁ and S_{1A}), (II₂ and S_{2A}), (II₃ and S_{3A}), (II₄ and S_{4A}), and (II₅ and S_{5A)} respectively. Flip flop FF₁ is reset by the input signal IP through inverter II₁.

At the power on, when the input signal IP is low (0), if a flip flop becomes active for example FF₁, the input pulse IP (0) will be sent to the positive output (Q). Therefore, the output (QB) becomes (1) and resets the following flip flop FF₂ through S_{1B}. Every time a flip flop is by passed for example FF₁, then its input (input pulse 0) will reset the following flip flop FF₂ through II₁ and S_{1A}. As a result, when the input signal is low the delay block DL₁ will be reset and OUT₁ becomes 0. Once the input signal IP becomes high (1), then the logic diagram of Figure 8 creates delays as described for the logic diagram of Figure 6.

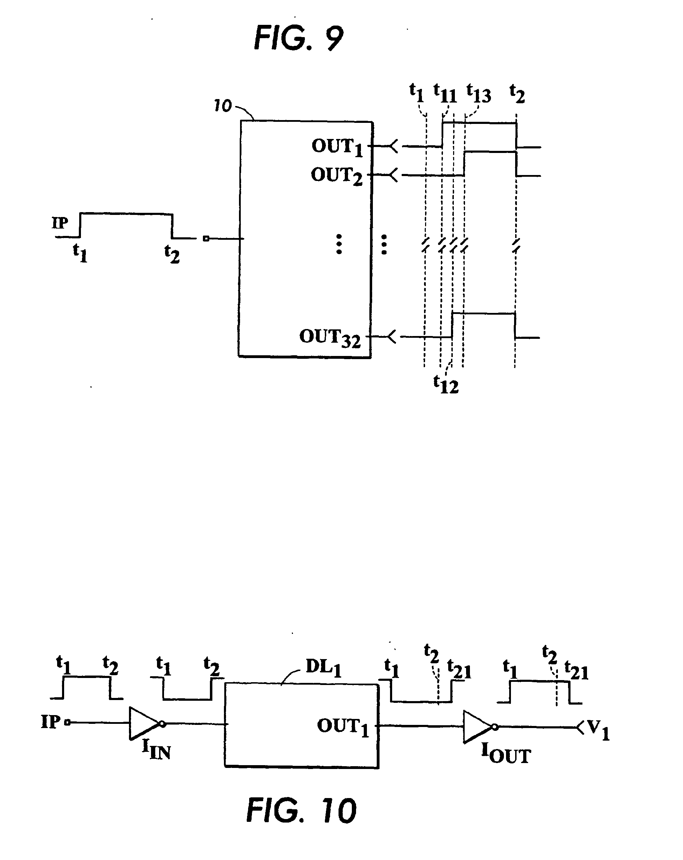

Referring to Figure 9, when an input signal IP with a rising edge at t₁ and a falling edge at t₂ is sent to the delay logic 10 of Figure 3, each line will delay the rising edge of the same input pulse IP with a different delay value. Therefore, Output lines OUT₁, OUT₂ and OUT₃₂ delay the rising edge of IP and send it out at t₁₁, t₁₃ and t₁₂ respectively. However, when the falling edge of the input pulse IP at t₂ enters logic 10, all the outputs OUT₁, OUT₂ and OUT₃₂ will become 0. It should be noted that each line can have a different delay and therefore each output can have less or more delay than what is shown. The delay logic 10 provides pulse width modulation since each line sends out a signal with a rising edge that has a different timing, but a falling edge concurrent with the falling edge of the signals of the other outputs OUT₁-OUT₃₂. As a result, the width of each output pulse is determined by its respective delay value V₁-V₃₂.

The logic diagram of Figure 3 is designed to create 0 - 64T delays for each signal of 32 lines. However, the concept of this invention can be applied to different number of delays on different number of lines.

Referring to Figure 10, there is shown an alternative pulse width modulation of this invention. In Figure 10, the input pulse IP is inverted through inverter I_{IN} before applying to block DL₁ and the output OUT₁ of DL₁ is connected to inverter I_{OUT}. In Figure 10, the rising edge of the input pulse IP at t₁ will reset the DL₁ block and the falling edge of the input pulse t₂ will be delayed. Therefore, I_{OUT} sends out a signal with a rising edge at t₂ and a falling edge at t₂₁ (the delayed falling edge of the input pulse IP). If this inversion is applied to all blocks DL₁-DL₃₂ of Figure 3, they will provide pulse width modulation by concurrently sending out the rising edge of the input pulse and delaying the falling edge of the input pulse IP according to their respective delay values V₁-V₃₂.

Referring back to Figure 3, each delay block DL₁-DL₃₂ has six flip flops (Figures 6 and 7) and clock divide block CD has five flip flop. Therefore, the logic diagram of Figure 3 has (32X6)+5=197 flip flops as opposed to 2068 flip flops of the prior art. The disclosed embodiment of this invention significantly reduces the number of flip flops, the silicon real estate, the size of the packaged chip, and finally the cost of the system using this chip.

It should be noted that numerous changes in details of construction and the combination and arrangement of elements may be resorted to without departing from the invention as hereinafter claimed.

## Claims

1. A pulse width modulation circuit comprising:
a clock dividing means (CD) for receiving a system clock (CLK) and generating a plurality of clocks (C₁-C₆) with different clock cycles (T, 2T, 4T, 8T, 16T, 32T);
a delaying means (DL₁-DL₃₂) for receiving a signal (IP) and delaying said signal;
said delaying means having a plurality of delaying elements (FF₁-FF₈);
each of said plurality of delaying elements (FF₁-FF₈) receiving one of said plurality of clocks (C₁-C₆);
said delaying means (DL₁-DL₃₂) receiving a delay data (V₁-V₃₂) and being responsive to said delay data (V₁-V₃₂) for selecting a number of said plurality of clocks (C₁-C₆) based on the delay data (V₁-V₃₂) and activating said respective delaying elements (FF₁-FF₆); and
said delaying means (DL₁-DL₃₂) being so constructed and arranged to cause the signal to pass through said activated delaying elements (FF₁-FF₆) and bypass said inactivated delaying elements.

2. The pulse width modulation circuit as recited in claim 1 further comprising a synchronizing block for synchronizing said system clock with the rising edge of said signal prior to delivery to said clock dividing means.

3. The pulse width modulation circuit as recited in claim 1 or 2, wherein said plurality of delaying elements are positive edge triggered D flip flops.

4. A pulse width modulation circuit as recited in claim 1, 2 or 3, wherein the said signal has a rising edge and a falling edge and the delaying means delays aid rising edge of said signal and further comprises reset means responsibe to said falling edge of said signal for resetting said delaying means.

5. A pulse width modulation circuit as recited in any preceding claim comprising a plurality of delaying means for receiving a signal and delaying said signal according to a plurality of data.

6. A pulse width modulation circuit as recited in any of the preceding claims, said delaying means further having a plurality of switches, said plurality of switches responsive to said delay data to cause said signal to pass through said activated delaying elements and bypass said inactivated delaying elements.

7. A pulse width modulation circuit as recited in any of the preceding claims, wherein said delaying elements are connected in series, each delaying element associated with two of said plurality of switches, one which acts to bypass said signal around said delaying element when closed and one which acts to pass said signal through said delaying element when closed.

8. A pulse width modulation circuit as recited in any of the preceding claims, wherein said delaying elements are flip flops.

## Patentansprüche

1. Schaltung für die Impulsbreitenmodulation, die aufweist:
eine Taktteilungseinrichtung (CD) zum Aufnehmen eines Systemtakts (CLK) und zum Erzeugen einer Vielzahl von Takten (C₁-C₆) mit unterschiedlichen Taktzyklen (T, 2T, 4T, 8T; 16T, 32T);
eine Verzögerungseinrichtung (DL₁-DL₃₂) zum Aufnehmen eines Signals (IP) und zum Verzögern des Signals;
wobei die Verzögerungseinrichtung eine Vielzahl von Verzögerungselementen (FF₁-FF₈) besitzt;
wobei jedes der Vielzahl der Verzögerungselemente (FF₁-FF₈) einen der Vielzahl der Takte (C₁-C₆) aufnimmt;
wobei die Verzögerungseinrichtung (DL₁-DL₃₂) Verzögerungsdaten (V₁-V₃₂) aufnimmt und auf die Verzögerungsdaten (V₁-V₃₂) zum Auswählen einer Anzahl der Vielzahl der Takte (C₁-C₆) basierend auf den Verzögerungsdaten (V₁-V₃₂) anspricht und die jeweiligen Verzögerungselemente (FF₁-FF₆) aktiviert; und
wobei die Verzögerungseinrichtung (DL₁-DL₃₂) so aufgebaut und angeordnet ist, um zu bewirken, lass das Signal durch die aktivierten Verzögerungselemente (FF₁-FF₆) hindurchführt und an den nicht aktivierten Verzögerungselementen im Bypass vorbeiführt.

2. Schaltung für die Impulsbreitenmodulation nach Anspruch 1, die weiterhin einen synchronisierenden Block zum Synchronisieren des System-Takts mit der ansteigenden Flanke des Signals vor einer Zuführung zu der Taktteilungseinrichtung aufweist.

3. Schaltung für die Impulsbreitenmodulation nach Anspruch 1 oder 2, wobei die Vielzahl der Verzögerungselemente über die positive Flanke getriggerte D-Flip-Flops sind.

4. Schaltung für die Impulsbreitenmodulation nach Anspruch 1, 2 oder 3, wobei das Signal eine ansteigende Flanke und eine abfallende Flanke besitzt und die Verzögerungseinrichtung die ansteigende Flanke des Signals verzögert, und weiterhin eine Reset-Einrichtung aufweist, die auf die abfallende Flanke des Signals zum Zurücksetzen der Verzögerungseinrichtung anspricht.

5. Schaltung für die Impulsbreitenmodulation nach einem vorhergehenden Anspruch, die eine Vielzahl von Verzögerungseinrichtungen zum Aufnehmen eines Signals und zum Verzögern des Signals entsprechend einer Vielzahl von Daten aufweist.

6. Schaltung für die Impulsbreitenmodulation nach einem der vorhergehenden Ansprüche, wobei die Verzögerungseinrichtung weiterhin eine Vielzahl von Schaltern hat, wobei die Vielzahl der Schalter auf die Verzögerungsdaten anspricht, um zu bewirken, dass das Signal durch die aktivierten Verzögerungselemente hindurchführt und im Bypass an den nicht aktivierten Verzögerungselementen vorbeiführt.

7. Schaltung für die Impulsbreitenmodulation nach einem der vorhergehenden Ansprüche, wobei die Verzögerungselemente in Reihe verbunden sind, wobei jedes Verzögerungselement zu zwei der Vielzahl der Schalter zugeordnet ist, wobei einer dahingehend wirkt, das Signal an dem Verzögerungselement im Bypass vorbeizuführen, wenn er geschlossen ist, und wobei einer dahingehend wirkt, das Signal durch das Verzögerungselement zuführen, wenn er geschlossen ist.

8. Schaltung für die Impulsbreitenmodulation nach einem der vorhergehenden Ansprüche, wobei die Verzögerungelemente Flip-Flops sind.

## Revendications

1. Circuit à modulation de largeur d'impulsions comprenant:
un moyen de division d'horloge (CD) pour recevoir une horloge système (CLK) et générer une pluralité d'horloges (C₁ - C₆) avec des cycles d'horloges différents (T, 2T, 4T, 8T, 16T, 32T);
un moyen de retardement (DL₁-DL₃₂) pour recevoir un signal (IP) et retarder ledit signal;
ledit moyen de retardement ayant une pluralité d'éléments de retardements (FF₁ - FF₈);
chacun de ladite pluralité d'éléments de retardement (FF₁ - FF₈) recevant l'une de ladite pluralité d'horloges (C₁- C₆);
ledit moyen de retardement (DL₁ - DL₃₂) recevant une donnée de retard (V₁ - V₃₂) et étant sensible à ladite donnée de retard (V₁ - V₃₂) pour Sélectionner un nombre de ladite pluralité d'horloges (C₁ - C₆) sur la base de la donnée de retard (V₁-V₃₂) et activer lesdits éléments de retardement respectifs (FF₁ - FF₆); et
ledit moyen de retardement (DL₁ - DL₃₂) étant construit et agencé de sorte à amener le signal à passer à travers lesdits éléments de retardement activés (FF₁ - FF₆) et à contourner lesdits éléments de retardement non activés.

2. Circuit à modulation de largeur d'impulsions selon la revendication 1 comprenant en plus un bloc de synchronisation pour synchroniser ladite horloge système avec le bord ascendant dudit signal avant livraison audit moyen de division d'horloge.

3. Circuits à modulation de largeur d'impulsion selon la revendication 1 ou 2, dans lequel ladite, pluralité d'éléments de retardement sont des bascules positives de type D déclenchées par un front d'impulsion.

4. Circuit à modulation de largeur d'impulsions selon la revendication 1, 2 ou 3, dans lequel ledit signal a un bord ascendant et un bord descendant et le moyen de retardement retardé ledit bord ascendant dudit signal et comprend en plus un moyen de réinitialisation sensible audit bord descendant dudit signal pour réinitialiser ledit moyen de retardement.

5. Circuit à modulation de largeur d'impulsions selon l'une quelconque des revendications précédentes comprenant une pluralité de moyens de retardement pour recevoir un signal et retarder ledit signal selon une pluralité de données.

6. Circuit à modulation de largeur d'impulsions selon l'une quelconque des revendications précédentes, ledit moyen de retardement ayant en plus une pluralité de commutateurs, ladite pluralité de commutateurs sensible à ladite donnée de retard pour amener ledit signal à passer à travers lesdits éléments de retardement activés et à contourner lesdites éléments de retardement non activés.

7. Circuit à modulation de largeur d'impulsions selon l'une quelconque des revendications précédentes, dans lequel lesdits éléments de retardement sont connectés en série, chaque élément de retardement associé à deux de la pluralité de commutateurs, l'un qui agit pour contourner ledit signal autour dudit élément de retardement lorsqu'il est fermé, et l'un qui agit pour faire, passer ledit signal à travers ledit élément de retardement lorsqu'il est fermé.

8. Circuit à modulation de largeur d'impulsions selon l'une quelconque des revendications précédentes, dans lequel lesdits éléments de retardement sont des bascules.
